# EUROPEAN PATENT SPECIFICATION

(11) **EP 4 203 015 B1**
(45) Date of publication and mention of the grant of the patent: **27.05.2026**
(21) Application number: 21216821.5
(22) Date of filing: 22.12.2021
(51) Int. Cl.: H10W 40/25, H10W 40/77

(54) **HEIGHT ADAPTABLE MULTILAYER SPACER**
HÖHENANPASSBARER MEHRSCHICHTIGER ABSTANDSHALTER
ESPACEUR MULTICOUCHE RÉGLABLE EN HAUTEUR

(43) Date of publication of application: 28.06.2023
(73) Proprietor: Heraeus Electronics GmbH & Co. KG, 63450 Hanau (DE)
(72) Inventor: HINRICH, Andreas, 62579 Freigericht (DE)
(74) Representative: Heraeus IP

(56) References cited:
- US-A- 5 156 923
- US-A1- 2005 224 955
- US-A1- 2018 033 716
- US-A1- 2021 358 829

## Description

The invention relates to a metal layer stack suitable as a spacer for power electronics, a semiconductor module comprising the metal layer stack and a process for fabricating such a metal layer stack.

In modern power electronics, for example in electric vehicles (EV) there is an ongoing trend towards higher and higher power densities. One of the biggest challenges in these modules is to dissipate the heat generated by the semiconductor. One approach is to use spacers on the surface of the chip which can help to guide the heat to a suitable heatsink.

In the state of the art the spacer is made of a solid block of material, which is mostly copper or special CTE-adapted materials (molybdenum, tungsten, etc.). These are almost exclusively soldered since no pressure needs to be applied during bonding and solder is generally capable of bridging small gaps by forming a meniscus in the molten state.

All known technologies have in common that for the different distances to be bridged in the module, separate spacers must be built. In addition, the change from soldering to low-temperature pressure sintering is beneficial to create joints with higher thermal stability but it remains challenging, since small height tolerances lead to strong effects in the pressure distribution, especially when sintering several spacers within a module. There is in principle also the possibility to sinter without the application of pressure. However, non-pressure sintering conventionally results in sinter joints exhibiting a high voiding and thus the long-time and/or temperature stability of these non-pressure sinter joints is low. Nevertheless, it has been observed that sintering of spacers can damage sensitive chip structures (e.g. gate runners) and therefore the sintering pressure must be reduced to a minimum. US 5 156 923 A (JHA SUNIL C [US] ET AL) 20 October 1992 (1992-10-20) discloses a heat-transferring circuit substrate comprising alternating metal layers laminated together. US 2018/033716 A1 (VISWANATHAN LAKSHMINARAYAN [US]) 1 February 2018 (2018-02-01) discloses a sintered multilayer heat sink for microelectronic packages. Furthermore, US 2021/358829 A1 (YOU MYUNG ILL [KR] ET AL) 18 November 2021 (2021-11-18) discloses a multi-layered spacer for a power module.

It is thus an object of the invention to overcome at least one disadvantage of the prior art. In particular it is an object of the invention to provide a spacer which can easily be adapted to bridge different heights in a power electronic module.

Furthermore, it is an object of the invention to provide a spacer which exerts less pressure on sensitive components like gate runners during production while still enabling joints with high thermal and mechanical stability, when compared to spacers of the prior art.

The object is solved by the subject matter of the independent claims. The dependent claims specify preferred embodiments of the invention.

In a first aspect the invention relates to a metal layer stack for use in electronic components comprising n bulk metal layers and n+1 layers of a contact material, wherein the bulk metal layers and the contact material layers are stacked in an alternating manner and n is at least two, , wherein the metal layer stack contains a contact material layer, wherein the contact material layer comprises a sinter material and wherein the sinter material is a sinter precursor or a sintered joint.

In case the number of contact material layers is n+1 the first and the last layer each comprise a contact material.

This metal layer stack is particularly suitable as a spacer in electronic components, and more particular in power electronic components. Preferably it may be used to flexibly bridge the gap between a semiconductor chip and a respective heat sink without damaging sensitive structures, e.g. on the semiconductor chip. The heat sink can for example be a metal containing substrate.

It is possible to build the metal layer stack from standardized layer assemblies containing one bulk metal layer wherein a contact material layer is arranged on at least one surface of the bulk metal layer. Through this modular approach which uses standardized thicknesses of the layer assembly, spacers for various heights can be provided at low costs, just by selecting the right number of layer assemblies.

The metal layer stack comprises at least two different kinds of metal layers. The metal layers include bulk metal layers and contact material layers. A metal layer comprises or consists of metal. Thus, it is preferably electrically and thermally conductive

An advantage of the metal layer stack of the invention, if used as a spacer, is that height tolerances can be compensated much easier and more effectively compared to a conventional spacer where only one contact material layer is arranged on each side of a block of metal.

The term "bulk" in this context means that the metal does not exhibit any intentional porosity. For example, the relative density of the bulk metal layer is greater than 99.9%. The term bulk may also be understood as a "massive" metal layer and stands in contrast to a metal layer which is produced from particles.

The metal of the bulk metal layer preferably comprises or consists of an element selected from the group consisting of copper, molybdenum, tungsten, silver and aluminium. Most preferably the bulk metal layer comprises copper. A bulk metal layer may comprise or consist of an elemental metal or an alloy. The elemental metal in the context of the invention means that the metal only consists of one element apart from unavoidable impurities. In a preferred embodiment the amount of impurities in the elemental metal does not exceed 1 wt.-%, in particular it does not exceed 0.1 wt.-% or even 0.01 wt.-%. The impurities can be metallic, e.g. silver, or non-metallic impurities, e.g. oxygen. The alloy comprises a combination of at least one metal with at least one alloying component wherein the combination has metallic properties. For the sake of clarity, the at least one metal and the at least one alloying component are not the same. The at least one alloying component may be selected form the group of metals, semi-metals and non-metals. Preferably the at least one alloying component is selected from the group consisting of copper, molybdenum, tungsten, silver, aluminium, and combinations thereof.

The thickness of a bulk metal layer preferably is in the range from 30 µm to 1000 µm, preferably 50 µm - 600 µm. The dimensions in x- and y-direction preferably are in the range from 500 µm to 20 mm. The bulk metal layers of the metal layer stack may have the same size or different sizes. Preferably each bulk metal layer of the metal layer stack has the same thickness. Alternatively, at least one of the bulk metal layers may have a different thickness compared to the remaining bulk metal layers of the stack.

In an optional embodiment one or more of the bulk metal layers of the metal layer stack may comprise a barrier layer. A barrier layer preferably comprises a material selected from silver and nickel, preferably nickel alloys, like e.g. NiPdAu NiAg and NiAu. Preferably the barrier layer is located between a bulk metal layer and a contact material layer.

In addition, the metal layer stack contains a contact material layer. The contact formed by the contact material layer is preferably an electrical contact, a thermal contact and a mechanical contact or a combination of the foregoing. The average thickness of the contact material layer preferably is at least 5 µm and more preferably at least 10 µm. The average thickness of the contact material layer preferably is at most 100 µm and in particular at most 50 µm.

The contact material layer contains sinter precursor or a sintered joint. A sinter precursor is capable of being transformed into a sintered joint.

The contact material layer comprises a sinter material selected form a sinter precursor and a sintered joint. In case the contact material precursor is a sinter precursor, it may preferably be heated and / or pressed and / or ultrasonically treated to form a sintered joint. A sinter material comprises a metal. The sinter material, i.e. the sinter precursor or the sintered joint, preferably comprises or consists of an element selected from the group consisting of silver, copper, aluminium, tin, indium, bismuth, nickel and zinc or combinations thereof. Most preferably the metal in the sinter material comprises an element selected from silver and copper. In particular the metal of the sinter material comprises at least 80 wt.% of copper or silver and 0 - 20 wt.-% of a metal selected from the group comprising aluminium, tin, indium, bismuth, nickel and zinc, each based on the total weight of the metal.

In a preferred embodiment the sinter precursor can be selected from a sinter paste and a sinter foil. A sinter paste preferably comprises a metal powder containing an element specified for the sinter material herein. In addition, a sinter paste preferably contains a vehicle. The vehicle may contain one or more components selected from the group consisting of solvents, sintering aids, rheology modifiers, thermosetting resins and thermoplastic resins. The solvent in the vehicle may be an organic solvent or an aqueous solvent. In another preferred embodiment the sinter paste may comprise a component selected from graphite, graphene and conductive carbon, like e.g. CNTs. Optionally the sinter paste is a flowable sinter paste or a dried sinter paste. A dried sinter paste is solid which comprises fractions of the vehicle. Thus, the dried sinter paste does not flow at room temperature.

Sinter foils may comprise a metal powder which has been arranged to a certain dimension and stabilized in a way that it keeps that dimension, e.g. a preformed and dried sinter paste in sheet form.

In a preferred embodiment the sinter precursor, in particular a sinter paste, can be converted into a sintered joint. A sintered joint, in particular when prepared from a sinter paste, preferably contains sintered particles which are connected to each other at their contact points to neighbouring particles. In a sintered joint the morphology of the sintered particles may be at least partly conserved. The conversion of a sinter precursor to a sintered joint takes place below the melting temperature of the metal contained in the sinter precursor.

Optionally, the metal layer stack may contain at least one additional layer. In a particularly preferred embodiment, every bulk metal layer of the metal layer stack is in contact with an additional layer. Additional layers may comprise at least one component selected from the group of barrier layers, sealant layers, sintering aids, fluxes, adhesion aids, dielectric layers, reversible or irreversible adhesive layers. In one embodiment the additional layer may be a prefixing agent. A prefixing agent may be used to temporarily and reversibly fix the metal layer stack to a carrier, e.g. during the production process or to facilitate the transport of the metal layer stack. Alternatively, the prefixing agent may be used to preliminary fix the metal layer stack to a semiconductor chip or a substrate, e.g. a DCB substrate, before the contact material precursor is converted into a joint material. This may allow easy stacking of metal layers.

In particular, the prefixing agent is an adhesive comprising thermoplastic polymer. The thermoplastic polymer may be present in an amount of 20 to 45% by weight in the prefixing agent. Further the prefixing agent may comprise an organic vehicle. The organic vehicle may be present in an amount of 40 to 70% by weight. An organic vehicle may comprise at least one organic solvent. Additionally, the prefixing agent my comprise 1 to 25% by weight of inorganic filler particles and 0 to 10% by weight of other additives.

Optionally the at least one additional layer may be arranged between at least one contact material layer and at least one bulk metal layer. In another preferred embodiment the at least one additional layer may be arranged next to at least one bulk metal layer or at least one contact material layer. For example, at least one additional layer may be arranged next to at least one contact material layer or at least one additional layer may surround at least one contact material layer.

The metal layer stack comprises n bulk metal layers and n+1 contact material layers, wherein the bulk metal layers and the contact material layers are stacked in an alternating manner, wherein n is at least two. In principle there is no upper limit for n but from a practical or economical point of view most likely the metal layer may not contain more than 20 - 30 bulk metal layers. Since the number of contact material layers is n+1, the first and the last layer of the metal layer stack comprise a contact material. In other words, in this embodiment the metal layers and the contact material layers of the metal layer stack are stacked in an alternating manner while the stack starts and ends with a contact material layer. The minimum amount of bulk metal layers is two. Thus, the minimum sequence is a five-layer stack of two bulk metal layers and three contact material layers. Taking this minimum metal layer stack of the invention as a starting point optionally one or more layer assemblies of a one bulk metal layer and one contact material layer can be added on top of the minimum sequence stack. This would result in three bulk metal layers combined with three contact material layers, four bulk metal layers combined with four contact material layers and so on. Optionally a final contact material layer may be arranged on the metal layer stack having an equal number of bulk metal layers and contact material layers. The more contact material layers are comprised in the metal layer stack, the better height tolerances and uneven surface topographies can be compensated by the stack when used as a spacer.

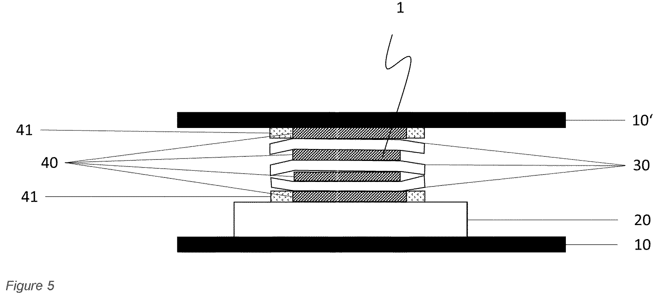

Optionally two bulk metal layers or two contact material layers do not stand in direct contact with each other. Alternatively, at least two of the bulk metal layers in the metal layer stack may stand in direct contact to each other. This can for example occur if a contact material layer is smaller than the two neighbouring bulk metal layers and these bulk metal layers bent towards each other. Optionally the sizes of the bulk metal layer and the contact material layer are the same or different. In particular the contact material layer can be smaller than the bulk metal layer. This scenario is exemplified in Figure 5.

The bulk metal layers of the metal layer stack can be the same or different. Preferably the bulk metal layers are of the same size and / or comprise the same material because this allows a material and cost-efficient production of the metal layer stack.

The contact material layers of the stack can be the same or different. For example, at least one of the terminal contact material layers, i.e. the first and / or the last contact material layer, may be different from at least one contact material layer stacked between two bulk metal layers. The contact material layers of a metal layer stack may for example have different compositions or different thicknesses. Preferably the contact material layers have the same composition. Preferably the contact material layers in the metal layer have the same thickness.

Preferably there are no restrictions to the geometry of the bulk metal layers and the contact material layers. For example, from the top view they can form a square, ellipsoid or round shape. It is preferred that the layers are rectangular.

In a second aspect the invention relates to a precursor for a spacer comprising a metal layer stack according to the invention, wherein at least one contact material layer comprises a sinter precursor material. Preferably the terminal contact material layers, i.e. the first and the last contact material layers of the stack, which are in contact with further components like e.g. a substrate or a semiconductor chip, comprise a sinter precursor material which has not been converted into a sintered joint. The precursor for a spacer may be produced at one location and transported to another location where it can be incorporated into a semiconductor module like e.g. a power electronic module.

In a third aspect the invention relates to a semiconductor module wherein a first surface of a semiconductor chip is in contact with a first contact material layer of the metal layer stack according to the invention as described herein. For the sake of clarity all specifications detailed for the metal layer stack in the previous section preferably also apply for the metal layer stack as part of the semiconductor module. The semiconductor module may for example be a power electronic module. A power electronic module typically is suitable for conducting and controlling high currents of up to several hundred Ampere.

In a preferred embodiment a substrate is attached to the last contact material layer of the metal layer stack. In other words, the metal layer stack establishes a connection between a semiconductor chip and a substrate. The connection preferably has good thermal and/or electrical conductivity.

In another preferred mode the semiconductor chip comprises an uneven surface topography. This may optionally occur if at least one electronic structure, like e.g. a gate runner, is arranged on the surface between the semiconductor chip and the metal layer stack. In particular, the gate runner is partially or fully covered by a terminal contact material layer.

In the semiconductor module the metal layer stack preferably functions as a spacer. A spacer can be seen as a component in an electronic or semiconductor module which is used to bridge a distance between two other components in order to establish good electrical and/or thermal contact. The metal layer stack as a spacer has the advantage that by stacking a number of bulk metal layers with standardized thicknesses different distances in a semiconductor module can be bridged in a highly flexible manner. Therefore, it is not required to produce spacers of different heights which are individually adjusted to bridge a certain gap, but the skilled person can choose a number of metal layers to create a spacer of the required height.

In the semiconductor module the metal layer stack has the positive effect that less pressure is applied to sensitive and elevated structures like gate runners during the production process, e.g. during sintering. Most likely this is because of the increased volume of formable contact material in the metal layer stack. Thus, if the metal layer stack functions as a spacer it can compensate uneven surfaces and height differences better than a stiff spacer of the prior art which comprises just one thicker bulk metal layer.

Preferably a second surface of the semiconductor chip opposite to the first surface contacts a second substrate. Optionally, one or more substrates of the semiconductor module may be selected from the group consisting of metal ceramic substrates, insulated metal substrates, organic substrates, substrates with organic insulators, lead frames, printed circuit boards and ceramic substrates.

In an optional embodiment the contact material of the metal layer stack is a sintered joint and the sintered joint exhibits a varying height thickness within a layer, or the sintered joint exhibits a varying density or porosity. This variation in density or height may optionally result from the compensation of differing heights in the semiconductor module or from the compensation of surface structures on a substrate or a semiconductor chip. For example, the density of one or more sinter material layers above a gate runner may be higher than next to the gate runner after pressure sintering.

Preferably all layers of the metal layer stack included in a semiconductor module have the same potential. Alternatively, and in particularly in the case where the metal layer stack comprises a dielectric layer within the stack, the layers of the metal layer stack may have different potentials.

In a preferred embodiment of the invention the semiconductor chip of the semiconductor module is in contact with at least two metal layer stacks. Preferably these at least two metal layer stacks in the semiconductor module have different potentials. This can be achieved for example if each of the contact pads of a semiconductor chip is in contact with a separate metal layer stack. For example, metal layer stacks can be arranged on each of a drain, a source and a gate contact of a semiconductor chip.

In a fourth aspect the invention relates to a process for producing a metal layer stack of the invention, comprising the steps:
a) Providing a carrier,
b) Providing a first layer assembly comprising a contact material precursor layer arranged on a bulk metal layer,
c) Arranging the first layer assembly on the carrier such that the contact material precursor layer is in contact with the carrier,
d) Providing a second layer assembly comprising a contact material precursor arranged on a bulk metal layer,
e) Arranging the second layer assembly on the bulk metal layer of the first layer assembly such that the contact material precursor of the second layer assembly is in contact with the bulk metal layer of the first layer assembly,
f) Optionally repeating steps d) and e), and wherein in the last sequence of steps d) and e) for preparing the metal layer stack the further layer assembly is different from previous layer assemblies, wherein the further layer assembly in the last sequence of steps d) and e) comprises a bulk metal layer wherein on both sides of that bulk metal layer a contact material precursor layer is arranged .

Optionally the process may contain additional steps before, between or after the specified steps a) to f). More preferably the sequence of steps a) to f) is not changed.

In step a) a carrier is provided. The carrier may be a semiconductor chip, a substrate, a part of a power electronic module or a temporal carrier.

In step b) a first layer assembly is provided wherein this first layer assembly comprises a contact material precursor layer arranged on a bulk metal layer. A layer assembly can for example be prepared by printing a contact material precursor layer on a bulk metal layer, e.g. by screen printing. Preferably the contact material precursor layer of the first layer assembly comprises a sinter paste. More preferably the sinter paste arranged on the bulk metal layer is dried. In a preferred embodiment the first layer assembly comprises an additional layer, in particular the additional layer is a prefixing agent, e.g. an adhesive.

In step c) the first layer assembly is arranged on the carrier such that the contact material precursor layer is in contact with the carrier. Optionally the contact material precursor may be converted into a joint material after arranging it on the surface of the carrier.

In step d) a further layer assembly comprising a contact material precursor arranged on a bulk metal layer is provided. Optionally the first and the further layer assembly are the same or different. In case the prepared metal layer stack comprises only two bulk metal layers the further layer assembly may be different. In this case the further layer assembly comprises a bulk metal layer wherein on both sides of that bulk metal layer respective contact material precursor layers are arranged. Alternatively, the first and the further layer assembly are the same. Preferably the second layer assembly is prepared in the same way as the first layer assembly.

In a particularly preferred embodiment, the further layer assembly of the last sequence of stacking layer assemblies is different from the previous layer assemblies. The last layer assembly comprises a bulk metal layer which has contact material precursor layers arranged on both surfaces of the bulk metal layer. This is to ensure that the last layer of the resulting metal layer stack is a contact material layer which can contact for example a substrate, like e.g. a DCB or a heat sink.

In step e) the further layer assembly is arranged on the bulk metal layer of the first layer assembly such that the contact material precursor of the second layer assembly is in contact with the bulk metal layer of the first layer assembly.

Optionally steps d) and e) are repeated until a metal layer stack is obtained and the required height of the metal layer stack is achieved. In accordance with the invention in the last sequence of steps d) and e) for preparing the metal layer stack the further layer assembly is different from previous layer assemblies. In particular the further layer assembly in the last sequence of steps d) and e) comprises a bulk metal layer wherein on both sides of that bulk metal layer a contact material precursor layer is arranged. In particular the specifications details for the bulk metal layer and the contact material layer can apply to the further layer assembly which is the last layer assembly of the process which has contact material layers arranged on both sides of the bulk metal layer.

In another preferred embodiment all layer assemblies used in this process are the same. This may result in a metal layer stack wherein the last layer of the metal layer stack is a bulk metal layer.

Optionally the process comprises step g) wherein at least one or all the contact material layers which comprise a contact material layer precursor are converted into joint materials. Preferably the metal layer stack after conversion of all contact material layer precursors into joint materials may be termed as a spacer.

The conversion of the contact material precursor into a joint material layer may be achieved by heating, by applying pressure, by applying chemicals, by applying electromagnetic radiation or by combinations thereof. The choice of the conversion method depends on the kind of contact material and the skilled person has the knowledge to choose the appropriate method.

In case the contact material precursor layer is heated it is preferably heated above the sintering temperature of the sinter precursor, e.g. <300°C.

Optionally the process comprises one or more heat treatment steps which are carried out at least after the last layer assembly is arranged characterized in that the contact material precursor is converted into a joint material.

Alternatively, the process can be started with a contact material layer on a carrier. Subsequently, a layer assembly may be arranged on that contact material layer such that the bulk metal layer of the layer assembly is in contact with the contact material layer. In the next step a further layer assembly is arranged on the first layer assembly such that the bulk metal layer of the further layer assembly is in contact with the contact material layer of the first layer assembly. In this way a metal layer stack may be obtained. The technical features detailed for the metal layer stack preferably also apply for this embodiment.

A fifth aspect relates to a process for producing a metal layer stack of the invention by consecutive and alternating stacking contact material layers and bulk metal layers.

For example, the process may comprise:
a) Providing a carrier,
b) Providing a contact material,
c) Applying a first contact material on the surface of the carrier such that a contact material layer is obtained,
d) Arranging a first bulk metal layer on the contact material layer.
e) Arranging a further contact material on the bulk metal layer to obtain a further contact material layer,
f) Arranging a further bulk metal layer on the surface of the further contact material layer and
g) Optionally repeating at least one or more of steps e) and f) until a metal layer stack of the invention is obtained.

In a preferred embodiment the metal layer stack obtained by this process is terminated with a bulk metal layer. Alternatively, the metal layer stack obtained by this process may be terminated with a contact material layer.

A sixth aspect relates to a process for producing a semiconductor module. The process preferably may include all steps specified for the process for producing a metal layer stack with the additional limitation that carrier in step a) of the process is a semiconductor chip or a substrate.

In one preferred embodiment the metal layer stack of the process for producing a semiconductor module comprises as the last layer a bulk metal layer. On this metal layer stack, a substrate, a heat sink or a chip may be arranged wherein the substrate the heat sink or the chip may comprise a contact metal layer which is in contact with the last bulk metal layer of the metal layer stack.

### Description of figures

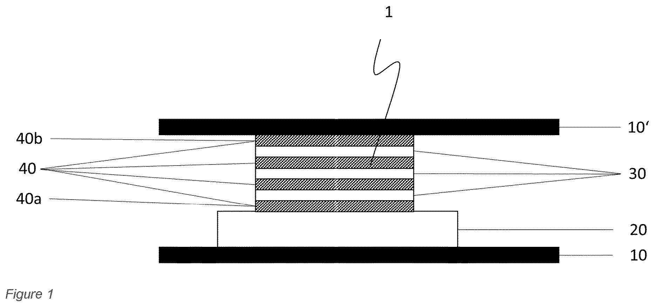

Figure 1 shows a semiconductor module comprising a metal layer stack (1), a semiconductor chip (20) and substrates (10 and 10'). The semiconductor chip (20) is arranged on a substrate (10). On the opposite surface of the semiconductor chip (20) a metal layer stack (1) is arranged. The metal layer stack (1) contains bulk metal layers (30) and contact material layers (40) wherein the bulk material layers (30) and the contact material layers (40) are stacked in an alternating manner. The last contact material layer (40b) of the metal layer stack (1) is in contact with a substrate (10'). The first contact material layer (40a) is in contact with the semiconductor chip (20).

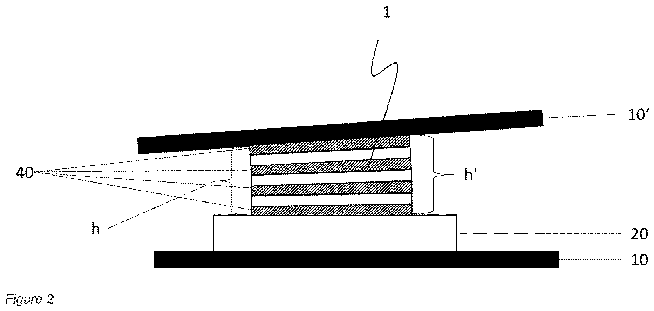

Figure 2 shows a semiconductor module wherein the metal layer stack (1) is located between a substrate (10') and a semiconductor chip (20) wherein the heights (h) and (h') differ from each other. The metal layer stack (1) is able to compensate for this height mismatch. The compensation of the height difference is mainly compensated by the contact material layer (40) which exhibit a varying amount of compression. The contact material layers (40) are more compressed on the left side of the semiconductor module compared to the right side. Thus, the overall height (h) is smaller than the overall height h'.

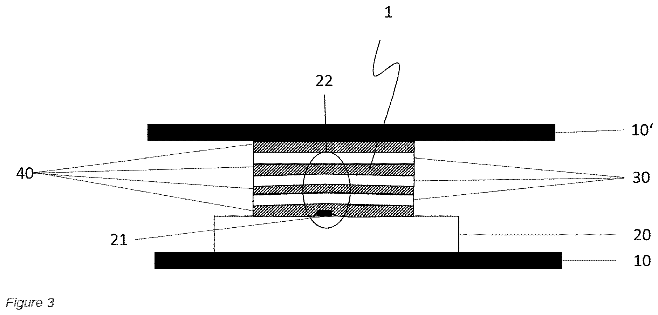

Figure 3 displays a semiconductor module wherein a gate runner (21) is located between the metal layer stack (1) and the surface of the semiconductor chip (20). As can be seen the metal layer stack (1) is particularly deformed in the region (22). This enables the metal layer stack (1) to compensate for surface roughness on the semiconductor chip (20). The deformation mainly takes place in the contact material layers (40). Optionally the density of the contact material layers (40) in the region (22) is higher than outside that region. The bulk metal layers (30) mainly bend to adjust to the gate runner (20) but they do not vary significantly in thickness. The fact that the metal layer stack is able to compensate the gate runner (21) in this example the substrates (10) and (10') can be oriented parallel to each other. Additionally, the fact that the metal layer stack compensates for the height variation due to the gate runner (21) pressure peaks on the semiconductor chip (20) can be prevented.

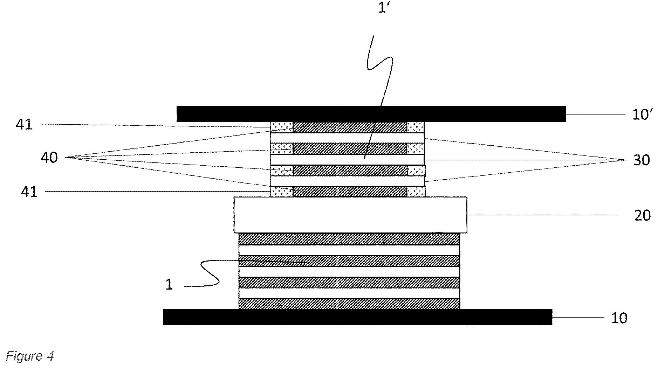

Figure 4 shows another embodiment of the semiconductor module wherein the metal layer stack (1') comprises additional layers (41). The additional layers (41) are arranged next to the terminal contact material layers of the metal layer stack (1'). The additional layers (41) may for example contain a prefixing agent. In case the additional layers (41) contain a prefixing agent, they can be used to prefix the metal layer stack to the surfaces of the substrate (10') and the semiconductor chip (20) respectively. Optionally the additional layers (41) can also be located between two bulk metal layers (30) as depicted in Figure 4. Alternatively, the additional layers (41) are only present in the terminal layers. Furthermore, the semiconductor module shown in Figure 4 comprises an additional metal layer stack (1) which is arranged on the opposite surface of the semiconductor chip (20). Preferably the contact between metal layer stack 1 and the semiconductor chip (20) is maximized to improve the dissipation of heat generated by the semiconductor chip (20).
Figure 5 shows an example of a semiconductor module wherein the bulk metal layers (30) of the metal layer stack (1) are bent towards each other. More specifically the lower two bulk metal layers (30) in Figure 5 are in contact with each other while the contact material layers (40) are smaller than the bulk metal layers (30).

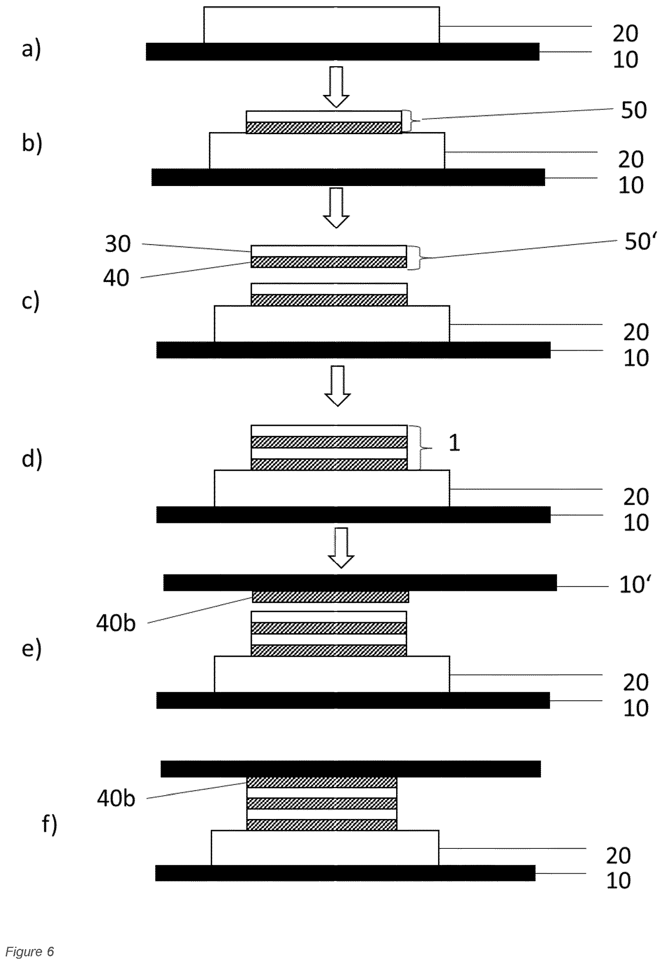

Figure 6 shows a schematic process for producing a metal layer stack and a semiconductor module. In 6 a) a semiconductor chip (20) on a substrate (10) is provided. In step 6 b) a first layer assembly (50) containing a contact metal layer (40) which is arranged on a bulk metal layer (30). The contact metal layer (40) faces the semiconductor chip. In step 6 c) a further layer assembly (50') is provided. The further layer assembly (50') is the last layer assembly which is added to the metal layer stack. Optionally the contact material layers (40) may be arranged on both sides in this further layer assembly (not shown). The further layer assembly (50') is arranged on the bulk metal layer of the first layer assembly (50). After step 6 d) a metal layer stack (1) is obtained. At the same time a semiconductor module comprising a metal layer stack (1) is obtained. Optionally in step 6 e) another substrate 10' is arranged on the last layer of the metal layer stack. The substrate in step 6 e) comprises a contact material layer (40b) which may be seen as the last layer of the metal layer stack after conversion of the contact material precursor materials into joint materials. In cases where the last layer assembly of the process comprises contact material layers on both sides of the bulk metal layer, i.e. the terminal layers of the metal layer stack comprise a contact material layer, the further substrate (10') preferably does not have a contact material layer. Optionally, after step 6 e) the contact metal layers (40) of the metal layer stack may be converted from contact material precursor layers into joint materials. For example, if the contact material layer comprises a sinter precursor it can be converted into a sintered joint by pressure and/or heat (not shown). Step 6 f) shows another embodiment of the semiconductor module according to the invention which may be obtained by the process of the invention.

### List of reference numerals

(1, 1') metal layer stack
(10, 10') Substrate
(20) Semiconductor chip
(21) gate runner
(22) region (above the gate runner)
(30) bulk metal layer
(40) contact material
(40a) first contact material layer
(40b) last contact material layer
(41) additional layer
(50) first layer assembly
(50') further layer assembly
(h, h') height of the metal layer stack

## Claims

1. Metal layer stack (1, 1') for use in electronic components comprising n bulk metal layers (30) and n+1 contact material layers (40), wherein the bulk metal layers and the contact material layers are stacked in an alternating manner and n is at least two, wherein the metal layer stack contains a contact material layer wherein the contact material layer comprises a sinter material and wherein the sinter material is a sinter precursor or a sintered joint.

2. Metal layer stack according to claim 1, wherein the mean thickness of the contact material layer is in the range from 10 µm to 100 µm.

3. Metal layer stack according to any one of claims 1 or 2, wherein the bulk metal layer comprises a metal selected from the group consisting of copper, molybdenum, tungsten, silver, aluminium and combinations thereof.

4. Metal layer stack according to any one of claims 1 - 3, where the mean thickness of a bulk metal layer is in the range from 50 µm to 600 µm.

5. Metal layer stack according to any one of claims 1 - 4, wherein the sinter material comprises a metal selected from the group consisting of silver, copper, aluminium, tin, indium, bismuth, nickel and zinc.

6. Semiconductor module wherein a first surface of a semiconductor chip (20) is in contact with a first contact material layer of the metal layer stack according to any one of claims 1-5.

7. Semiconductor module according to claim 6, wherein a substrate (10, 10') is attached to the last contact material layer of the metal layer stack.

8. Semiconductor module according to claim 6 or 7, wherein at least one gate runner (21) is arranged between the semiconductor chip and the metal layer stack.

9. Semiconductor module according to any one of claims 6 - 8, wherein the metal layer stack functions as a spacer.

10. Semiconductor module according to any one of claims 6 - 9, wherein a second surface of the semiconductor chip opposite to the first surface contacts a second substrate.

11. Semiconductor module according to any one of claims 6 - 10, wherein one or more substrates of the semiconductor module are selected from the group consisting of metal ceramic substrates, organic substrates, insulated metal substrates, lead frames and ceramic substrates.

12. A precursor for a spacer comprising a metal layer stack according to any one of claims 1 - 5, wherein at least the first or the last contact material layer of the metal layer stack comprises a sinter precursor.

13. Process for producing a metal layer stack, according to any one of claims 1-5, comprising the steps:
a) Providing a carrier,
b) Providing a first layer assembly comprising a contact material precursor layer arranged on a bulk metal layer,
c) Arranging the first layer assembly on the carrier such that the contact material precursor layer is in contact with the carrier,
d) Providing a second layer assembly comprising a contact material precursor arranged on a bulk metal layer,
e) Arranging the second layer assembly on the bulk metal layer of the first layer assembly such that the contact material precursor of the second layer assembly is in contact with the bulk metal layer of the first layer assembly, and
f) Optionally repeating steps d) and e),
the process further comprising in the last sequence of steps d) and e) for preparing the metal layer stack the further layer assembly is different from previous layer assemblies, wherein
the further layer assembly in the last sequence of steps d) and e) comprises a bulk metal layer wherein on both sides of that bulk metal layer a contact material precursor layer is arranged.

14. Process according to claim 13, comprising a step g) of converting the contact material precursor layers into layers of joint material.

## Patentansprüche

1. Metallschichtstapel (1,1') zur Verwendung in elektronischen Bauteilen, umfassend n Massivmetallschichten (30) und n+1 Kontaktmaterialschichten (40), wobei die Massivmetallschichten und die Kontaktmaterialschichten in abwechselnder Weise gestapelt sind und n mindestens zwei ist, wobei der Metallschichtstapel eine Kontaktmaterialschicht enthält, wobei die Kontaktmaterialschicht ein Sintermaterial umfasst und wobei das Sintermaterial ein Sintervorläufer oder eine gesinterte Verbindung ist.

2. Metallschichtstapel nach Anspruch 1, wobei die mittlere Dicke der Kontaktmaterialschicht in dem Bereich von 10 µm bis 100 µm liegt.

3. Metallschichtstapel nach einem der Ansprüche 1 oder 2, wobei die Massivmetallschicht ein Metall umfasst, das ausgewählt ist aus der Gruppe bestehend aus Kupfer, Molybdän, Wolfram, Silber, Aluminium und Kombinationen davon.

4. Metallschichtstapel nach einem der Ansprüche 1 bis 3, wobei die mittlere Dicke einer Massivmetallschicht in dem Bereich von 50 µm bis 600 µm liegt.

5. Metallschichtstapel nach einem der Ansprüche 1 bis 4, wobei das Sintermaterial ein Metall umfasst, das ausgewählt ist aus der Gruppe bestehend aus Silber, Kupfer, Aluminium, Zinn, Indium, Bismut, Nickel und Zink.

6. Halbleitermodul, wobei eine erste Oberfläche eines Halbleiterchips (20) in Kontakt mit einer ersten Kontaktmaterialschicht des Metallschichtstapels nach einem der Ansprüche 1 bis 5 steht.

7. Halbleitermodul nach Anspruch 6, wobei ein Substrat (10,10') an der letzten Kontaktmaterialschicht des Metallschichtstapels befestigt ist.

8. Halbleitermodul nach Anspruch 6 oder 7, wobei mindestens eine Gate-Leiterbahn (21) zwischen dem Halbleiterchip und dem Metallschichtstapel angeordnet ist.

9. Halbleitermodul nach einem der Ansprüche 6 bis 8, wobei der Metallschichtstapel als Abstandshalter fungiert.

10. Halbleitermodul nach einem der Ansprüche 6 bis 9, wobei eine zweite Oberfläche des Halbleiterchips gegenüber der ersten Oberfläche ein zweites Substrat kontaktiert.

11. Halbleitermodul nach einem der Ansprüche 6 bis 10, wobei ein oder mehrere Substrate des Halbleitermoduls ausgewählt sind aus der Gruppe bestehend aus Metallkeramiksubstraten, organischen Substraten, isolierten Metallsubstraten, Leadframes und Keramiksubstraten.

12. Vorläufer für einen Abstandshalter, der einen Metallschichtstapel nach einem der Ansprüche 1 bis 5 umfasst, wobei mindestens die erste oder die letzte Kontaktmaterialschicht des Metallschichtstapels einen Sintervorläufer umfasst.

13. Verfahren zum Erzeugen eines Metallschichtstapels nach einem der Ansprüche 1 bis 5, umfassend die Schritte:
a) Bereitstellen eines Trägers,
b) Bereitstellen einer ersten Schichtanordnung, die eine Kontaktmaterial-Vorläuferschicht umfasst, die auf einer Massivmetallschicht angeordnet ist,
c) Anordnen der ersten Schichtanordnung auf dem Träger derart, dass die Kontaktmaterial-Vorläuferschicht in Kontakt mit dem Träger steht,
d) Bereitstellen einer zweiten Schichtanordnung, die ein auf einer Grundmetallschicht angeordnetes Kontaktmaterial-Vorläufermaterial umfasst,
e) Anordnen der zweiten Schichtanordnung auf der Massivmetallschicht der ersten Schichtanordnung derart, dass der Kontaktmaterialvorläufer der zweiten Schichtanordnung in Kontakt mit der Massivmetallschicht der ersten Schichtanordnung steht, und
f) wahlweise Wiederholen der Schritte d) und e),
der Prozess ferner umfassend in der letzten Sequenz von Schritten d) und e) zur Herstellung des Metallschichtstapels, dass die weitere Schichtanordnung sich von vorherigen Schichtanordnungen unterscheidet, wobei die weitere Schichtanordnung in der letzten Sequenz von Schritten d) und e) eine Massivmetallschicht umfasst, wobei auf beiden Seiten dieser Massivmetallschicht eine Kontaktmaterial-Vorläuferschicht angeordnet ist.

14. Verfahren nach Anspruch 13, umfassend einen Schritt g) des Umwandelns der Kontaktmaterial-Vorläuferschichten in Schichten aus Verbindungsmaterial.

## Revendications

1. Empilement de couches métalliques (1, 1') destiné à être utilisé dans des composants électroniques comprenant n couches métalliques massives (30) et n + 1 couches de matériau de contact (40), dans lequel les couches métalliques massives et les couches de matériau de contact sont empilées de manière alternée et n est au moins égal à deux, dans lequel l'empilement de couches métalliques contient une couche de matériau de contact, dans lequel la couche de matériau de contact comprend un matériau de frittage, et dans lequel le matériau de frittage est un précurseur de frittage ou un joint fritté.

2. Empilement de couches métalliques selon la revendication 1, dans lequel l'épaisseur moyenne de la couche de matériau de contact est comprise dans la plage allant de 10 µm à 100 µm.

3. Empilement de couches métalliques selon l'une quelconque des revendications 1 ou 2, dans lequel la couche métallique massive comprend un métal choisi dans le groupe constitué de cuivre, molybdène, tungstène, argent, aluminium et combinaisons de ceux-ci.

4. Empilement de couches métalliques selon l'une quelconque des revendications 1 à 3, où l'épaisseur moyenne d'une couche métallique massive est comprise dans la plage allant de 50 µm à 600 µm.

5. Empilement de couches métalliques selon l'une quelconque des revendications 1 à 4, dans lequel le matériau de frittage comprend un métal choisi dans le groupe constitué d'argent, cuivre, aluminium, étain, indium, bismuth, nickel et zinc.

6. Module semi-conducteur, dans lequel une première surface d'une puce semi-conductrice (20) entre en contact avec une première couche de matériau de contact de l'empilement de couches métalliques selon l'une quelconque des revendications 1 à 5.

7. Module semi-conducteur selon la revendication 6, dans lequel un substrat (10, 10') est fixé à la dernière couche de matériau de contact de l'empilement de couches métalliques.

8. Module semi-conducteur selon la revendication 6 ou 7, dans lequel au moins un canal de grille (21) est disposé entre la puce semi-conductrice et l'empilement de couches métalliques.

9. Module semi-conducteur selon l'une quelconque des revendications 6 à 8, dans lequel l'empilement de couches métalliques fonctionne en tant qu'espaceur.

10. Module semi-conducteur selon l'une quelconque des revendications 6 à 9, dans lequel une seconde surface de la puce semi-conductrice opposée à la première surface entre en contact avec un second substrat.

11. Module semi-conducteur selon l'une quelconque des revendications 6 à 10, dans lequel un ou plusieurs substrats du module semi-conducteur sont choisis dans le groupe constitué de substrats céramiques métalliques, substrats organiques, substrats métalliques isolés, grilles de connexion et substrats céramiques.

12. Précurseur pour un espaceur comprenant un empilement de couches métalliques selon l'une quelconque des revendications 1 à 5, dans lequel au moins la première ou la dernière couche de matériau de contact de l'empilement de couches métalliques comprend un précurseur de frittage.

13. Procédé permettant de produire un empilement de couches métalliques, selon l'une quelconque des revendications 1 à 5, comprenant les étapes consistant à :
a) fournir un support,
b) fournir un premier ensemble de couches comprenant une couche de précurseur de matériau de contact disposée sur une couche métallique massive,
c) disposer le premier ensemble de couches sur le support de telle sorte que la couche de précurseur de matériau de contact soit en contact avec le support,
d) fournir un second ensemble de couches comprenant un précurseur de matériau de contact disposé sur une couche métallique massive,
e) disposer le second ensemble de couches sur la couche métallique massive du premier ensemble de couches de telle sorte que le précurseur de matériau de contact du second ensemble de couches soit en contact avec la couche métallique massive du premier ensemble de couches, et
f) répéter éventuellement les étapes d) et e),
le procédé comprenant en outre le fait que, dans la dernière séquence des étapes d) et e) permettant de préparer l'empilement de couches métalliques, l'ensemble de couches supplémentaire est différent des ensembles de couches précédents, dans lequel l'ensemble de couches supplémentaire dans la dernière séquence des étapes d) et e) comprend une couche métallique massive, dans lequel sur les deux côtés de cette couche métallique massive est disposée une couche de précurseur de matériau de contact.

14. Procédé selon la revendication 13, comprenant une étape g) consistant à convertir les couches de précurseur de matériau de contact en couches de matériau de joint.
